Europäisches Patentamt

European Patent Office

Office européen des brevets

(19)

(11) Publication number: **0 366 373**
**A2**

# EUROPEAN PATENT APPLICATION

(12)

(21) Application number: **89310837.3**

(22) Date of filing: **20.10.89**

(51) Int. Cl.⁵: **H03L 3/00 , H03L 1/02**

(30) Priority: **25.10.88 GB 8824967**

(43) Date of publication of application:
**02.05.90 Bulletin 90/18**

(84) Designated Contracting States:
**AT BE CH DE ES FR GB GR IT LI LU NL SE**

(71) Applicant: **THORN EMI plc**
**4 Tenterden Street**
**London W1A 2AY(GB)**

(72) Inventor: **Seymour, Colin Julian**
**60, Stuart Avenue**
**South Harrow Middlesex, HA2 9AZ(GB)**

(74) Representative: **Fleming, Ian Alexander et al**
**THORN EMI Patents Limited The Quadrangle**
**Westmount Centre Uxbridge Road**
**Hayes Middlesex, UB4 0HB(GB)**

(54) Oscillator with transient frequency response compensation.

(57) An oscillator circuit comprises an oscillator 10, a modulator 11, a temperature compensation circuit 12 and a transient compensation circuit 13. The modulator 11 is provided with a further control input $I_3$ coupled to receive a control signal $V_{TC}$ provided by the transient compensation circuit 13. The control signal $V_{TC}$ is effective to compensate the transient frequency response of the oscillator 10 by having a variation, as a function of time, which causes an offset in the frequency response of the oscillator 10 which is substantially the inverse of the transient response it is intended to compensate. The signal $V_{TC}$ enables the frequency output of the oscillator 10 to stabilise rapidly within preset time limits, making the oscillator circuit particuarly suitable for transceivers having intermittent operation.

FIG.3(a)

## OSCILLATOR WITH TRANSIENT FREQUENCY RESPONSE COMPENSATION

This invention relates to oscillator circuits and it relates particularly, though not exclusively, to oscillator circuits which are intended to be turned on for relatively short periods of time; for example, oscillator circuits used in a radio frequency transmitter or a radio frequency receiver operating in an intermittent or sampling mode.

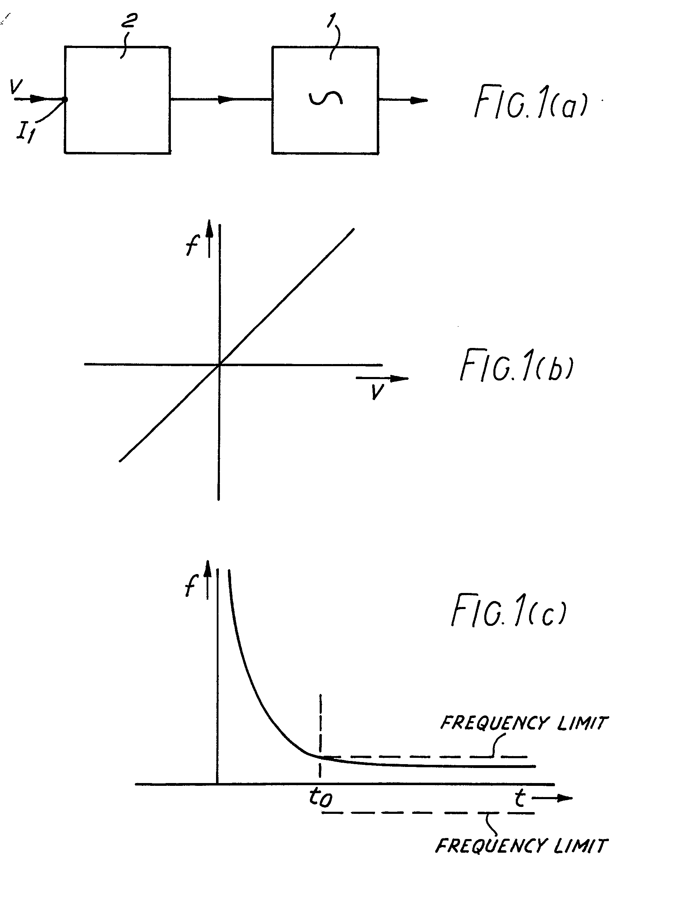

Figure 1(a) of the accompanying drawings shows a known oscillator circuit comprising an oscillator 1 and an associated frequency modulator 2, for example a varactor diode reactance modulator, having a control input $I_1$ arranged to receive a control voltage V. Figure 1 (b) of the drawings shows how the frequency output of that oscillator circuit varies as a function of control voltage V.

It is known that an oscillator circuit of the kind described by reference to Figures 1 does not attain a desired frequency immediately, but exhibits a transient frequency response. As shown to Figure 1 (c) a finite interval of time, $t_o$ is needed, after the oscillator circuit has been turned-on, in order to allow the frequency output to settle to a value which is within acceptable limits of the desired frequency and, in general, the shorter this time interval the larger will be the frequency error.

These transient effects can arise for a number of different reasons. If the oscillator is stabilised by a high-Q device, such as a quartz crystal, oscillations tend to grow relatively slowly giving rise to a corresponding frequency shift. Furthermore, the oscillator start frequency may not match the desired, steady state frequency.

When the oscillator circuit is switched on there may be a period during which d.c. levels of current in RF chokes and d.c. levels of voltage across capacitors are approaching their steady state values, and these changes may also give rise to transient effects. Furthermore, circuit components may initially undergo small, but significant, temperature changes creating a shift of frequency.

The net result of these diverse effects is that initially, the frequency output is in error and approaches the desired frequency values asymptotically.

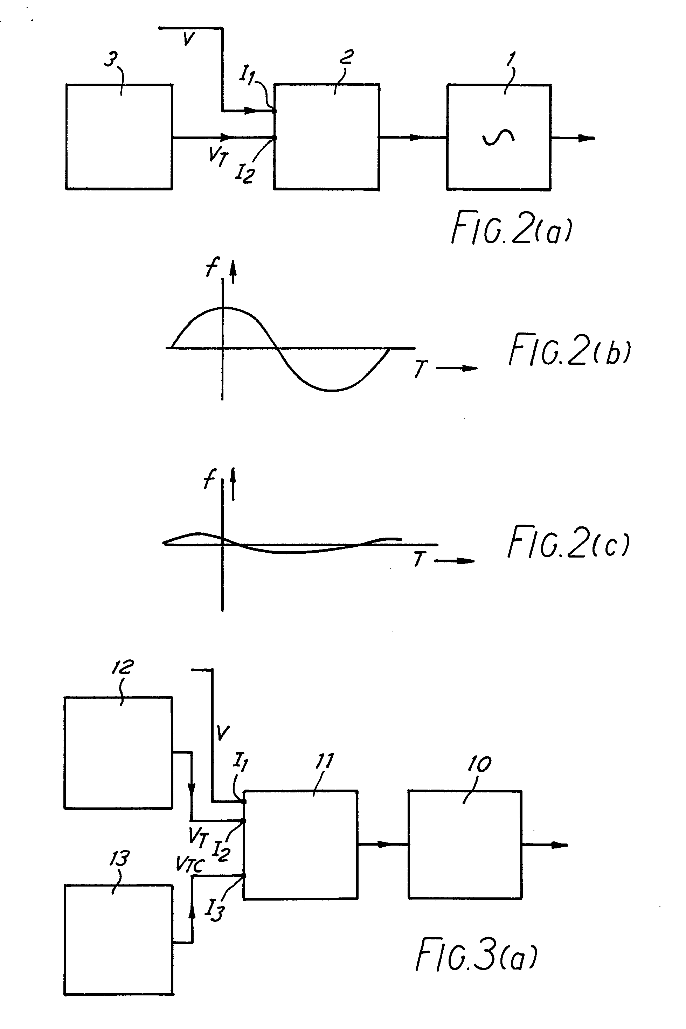

Superimposed on these transient effects is a long-term effect due to changes of ambient temperature and to ageing of circuit components. Figure 2 (a) shows how a temperature compensating network 3 is utilised, in known oscillator circuits, to alleviate the long-term temperature effects, the network being arranged to apply a temperature compensating voltage $V_T$ to a second control input $I_2$ of frequency modulator 2. Figures 2 (b) and 2 (c) show how the frequency output of the oscillator circuit changes as a function of ambient temperature T in the uncompensated and compensated circuits respectively.

In many applications, and particularly applications involving the transmission or reception of radio signals, it is desirable that the frequency output of the oscillator circuit should reach a stable value as quickly as possible since the correct frequency (within acceptable error limits) may be needed in order to comply with certain regulations (i.e. to confine transmission to an allocated frequency channel) and to match the receiver pass band to the transmitted frequency. It is therefore an object of the present invention to provide an oscillation circuit which is compensated, at least in part, for transient effects of the afore-mentioned kind.

According to a first aspect of the invention there is provided an oscillator circuit comprising a transient compensation circuit for providing a control signal and an oscillator having a transient frequency response and including a control input arranged to receive the control signal from the transient compensation circuit, the control signal being arranged to vary, as a function of time, in a manner for compensating, at least partially, the transient frequency response of the oscillator.

An oscillator circuit in accordance with the invention has a substantially reduced settling time and may also exhibit reduced frequency errors when the circuit is switched off.

Preferably, upon energisation of the oscillator circuit, the transient compensation circuit is arranged for energisation prior to energisation of the oscillator.

In order that the invention may be carried readily into effect embodiments thereof are now described, by way of example only, by reference to the accompanying drawings of which:-

Figure 1 (a) shows a known oscillator circuit,

Figure 1 (b) shows the variation as a function of an applied control voltage of the frequency output of the oscillator circuit shown in Figure 1 (a),

Figure 1 (c) shows the transient frequency response of the oscillator circuit shown in Figure 1 (a),

Figure 2 (a) shows another known oscillator circuit incorporating a temperature compensating network,

Figures 2 (b) and 2 (c) illustrate the variation of frequency output as a function of ambient temperature produced by the circuits of Figures 1 (a) and 2 (a) respectively,

Figure 3 (a) shows an oscillator circuit in accordance with the present invention,

Figure 3 (b) illustrates the variation, as a function of time, of a control signal (in this case a voltage) used in the oscillator circuit of Figure 3 (a),

Figure 3 (c) illustrates the variation, as a function of time, of the frequency output produced by the circuit of Figure 3 (a) immediately after the circuit has been switched on,

Figures 4 and 5 show a radio frequency transmitter and a radio frequency receiver respectively which incorporate oscillator circuits in accordance with the present invention,

and Figures 6 (a) to 6 (e) show signal waveforms used in operation of the radio frequency receiver shown in Figure 4.

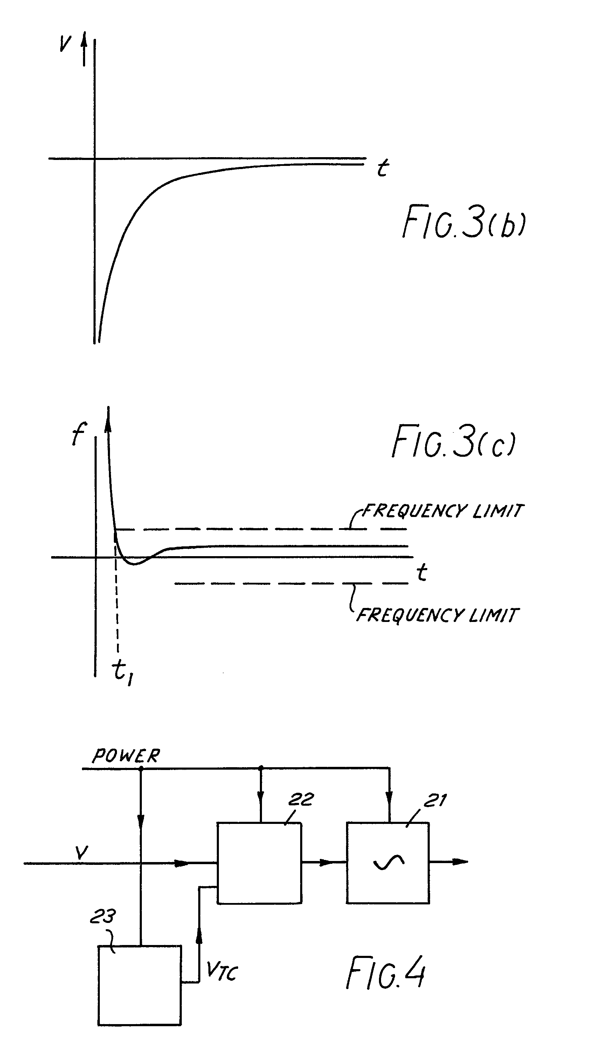

Referring now to Figure 3 (a), the oscillator circuit comprises an oscillator 10, a frequency modulation circuit 11 and a temperature compensation circuit 12 as described herein by reference to Figure 2 (a). However, in addition, the oscillator circuit shown in Figure 3 (a) also includes a transient compensation circuit 13 producing a further control voltage $V_{TC}$. The further control voltage is applied at a further control input $I_3$ of the modulation circuit and is effective to offset the transient frequency response of oscillator 10. To that end, the further control voltage has a variation as a function of time which is the inverse of the transient frequency variation it is intended to offset; that is to say, the control voltage gives rise to a frequency variation which is equal to, and in the opposite sense as, the frequency variation produced by transient effects. The control voltage shown in Figure 3 (b) is tailored to offset the transient frequency variations shown in Figure 1 (c). Figure 3 (c) shows the frequency output produced by the oscillator circuit of Figure 3 (a), and it will be readily apparent that the frequency output settles, at time $t_1$, to an acceptable value, within preset frequency limits, very much sooner than is possible using uncompensated oscillator circuits of the kind shown in Figure 2 (a), for example. The compensating control voltage takes effect in the very short term, enabling the oscillator frequency to be stable within a reduced time period from switch on, and possible also reducing frequency errors at switch-off, and it can, if required, continue to apply a compensating bias to compensate for thermal errors during warm-up.

A transient compensation circuit utilised in accordance with the present invention may consist solely of analogue components designed to generate a control voltage $V_{TC}$ when power is supplied thereto. In order to provide compensation when the oscillator circuit is turned off, the transient compensation circuit may be activated by application thereto of a suitable trigger signal, in advance of the oscillator circuit being turned off or, alternatively the oscillator circuit may be left in an uncompensated condition at switch off, especially in circumstances when the switch-on conditions are regarded as more critical.

The transient compensation circuit could be embodied using digital circuitry used either for the purposes of triggering or in order to generate the control voltage itself. Such digital circuitry might include digital signal processing circuits or microprocessor circuits operating in association with a digital-to-analogue interface. It is envisaged that digital techniques could prove particularly useful in circumstances when the oscillator circuit is switched on shortly after it has been turned off, a situation which might give rise to modified electrical and thermal transients.

A transient frequency-compensated oscillator circuit in accordance with the present invention finds particular, though not exclusive application, in intermittently-operated, radio frequency transmitters and receivers. In order to conserve battery power, a radio frequency transmitter or receiver is switched on for a short time and switched off for a longer time thereby enabling the average power consumption to be reduced. This is advantageous in systems that transmit status information infrequently or are not in continuous use.

Minimising the time taken between switch-on and attainment of a stable oscillator frequency reduces the wasted power during a short transmission, and also reduces the energy radiated outside an authorised channel. A transmitter may be switched off for long periods in order to conserve power, but a receiver would have to continuously monitor for transmissions, which might imply continuous power consumption. There are therefore greater power savings to be made in receivers operating in this manner.

The receiver power can be reduced by intermittent or sampling operation, and the time needed to attain a stable frequency from turn-on then becomes a critical factor if a high sampling rate is required. The receiver has to be on for long enough to detect transmissions in the correct channel, to be switched on frequently enough to detect transmissions within a reasonable delay time (when a transmmission is detected, a continuous receiver mode can be invoked) and to have a low enough duty cycle to achieve the required power conservation. In these circumstances a transient frequency compensated oscillator circuit could prove invaluable.

Figure 4 shows, in block schematic form, an example of a radio frequencer transmitter which uses a transient frequency compensation circuit to minimise the switch-on time. It includes an oscillator 21, a frequency modulator 22, and a transient compensation circuit 23.

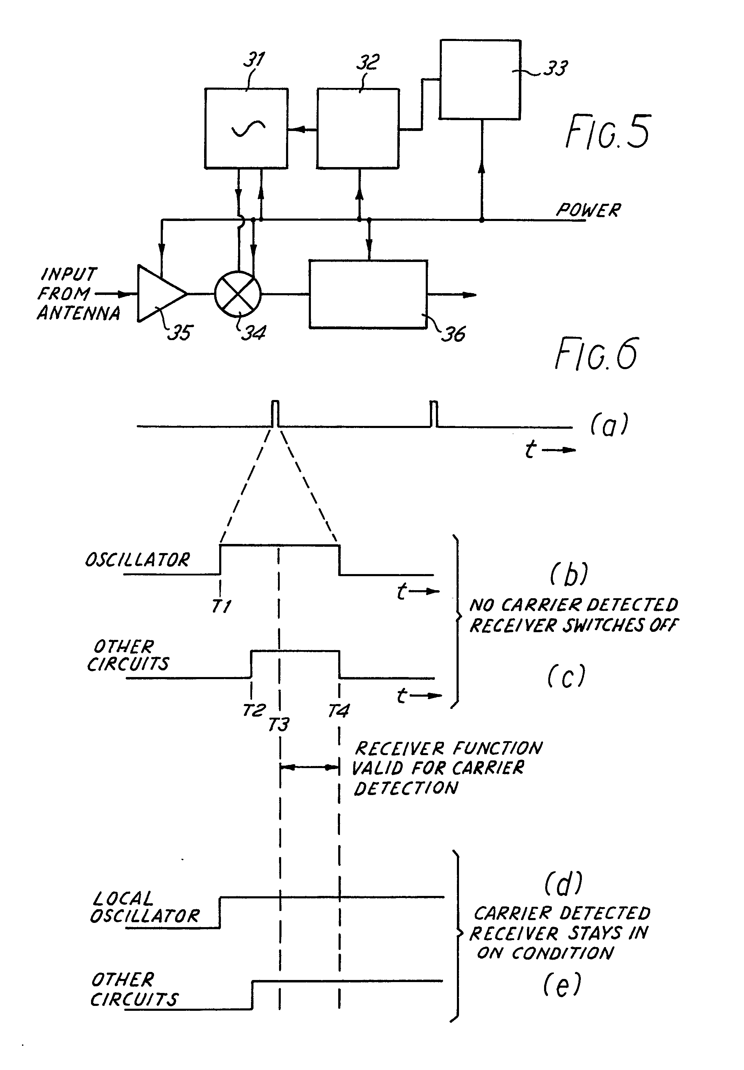

Figure 5 shows in block schematic form an example of part of a radio frequency receiver including an oscillator 31, a frequency modulator 32, a transient compensation circuit 33, a signal mixer 34, a radio frequency (RF) preamplifier 35, and intermediate frequency (if) circuits 36 to obtain the received signal. The transient compensation circuit 33 is used to operate the receiver in a sampling mode with minimum power consumption, the compensated oscillator operating as a first local oscillator.

Figures 6a to 6e show a timing sequence illustrating how the transient compensated sampling radio frequency receiver may operate, the radio frequency receiver being switched on intermittently by a sampling gate (Figure 6a) so that the power consumption is reduced according to the duty cycle.

Assuming that the first local oscillator takes the longest time to stabilise, a gate signal (Figure 6b) turns on the local oscillator first, at time $T_1$. The other circuits, such as mixers and amplifiers, stabilise in a shorter time than the oscillator and so these circuits may be gated on (Figure 6c) later, at time $T_2$, thereby to minimise power consumption. If a second local oscillator is used, it may stabilise in a sufficiently short time because of its much lower frequency, which reduces the frequency error pro rata, such that transient compensation of the kind described in accordance with this invention is unncessary; otherwise a second transient compensation circuit may be required and the second local oscillator may also have to be switched on at time $T_1$.

All local oscillators and other circuits are stable enough at the sampling time $T_3$ to enable a valid assessment to be made as to whether a signal is being received. During the interval from time $T_3$ to time $T_4$ the receiver evaluates whether a signal is being received, the duration of this period, and any associated windowing function, being taken into account when analysing the sampling window spectrum. If no signal is detected, as a Figures 6b and 6c, the receiver is switched off at time $T_4$ until the next sampling gate. If a signal is detected the receiver stays on as shown in Figures 6d and 6e enabling that signal to be retained for further processing.

As the transient frequency compensation circuit operates in open-loop fashion, calibration thereof is performed using external test equipment, such as a frequency discriminator, enabling optimum transient frequency compensation to be achieved. Alternatively, a standard, fixed calibration may be used, fine tuning being provided for individual oscillators, if desired.

It is envisaged that the present invention may find applications in many different fields of activity including, for example, cordless fire and security systems, paging radio receivers, personal communications systems (radios operating in a low power, stand by mode), low power radio remote control systems, radio monitoring systems and low power radio telemetry.

## Claims

1. An oscillator circuit comprising a transient compensation circuit for providing a control signal and an oscillator having a transient frequency response and including a control input arranged to receive the control signal from the transient compensation circuit, the control signal being arranged to vary, as a function of time, in a manner for compensating, at least partially, the transient frequency response of the oscillator.

2. An oscillator circuit according to Claim 1 further comprising a temperature compensation circuit for providing a bias signal arranged to compensate, as a function of temperature, a drift of the frequency response of the oscillator.

3. An oscillator circuit according to Claim 1 or Claim 2 wherein, upon energisation of the oscillator circuit, the transient compensation circuit is arranged for energisation prior to energisation of the oscillator.

4. An oscillator circuit according to any one of Claims 1 to 3 wherein, upon de-energisation of the oscillator circuit, the transient compensation circuit is arranged to provide a further control signal, being arranged to vary, as a function of time, in a manner for compensating, at least partially, the transient frequency response of the oscillator upon de-energisation.

5. An oscillator circuit according to any one of the preceding claims wherein the transient compensation circuit includes means for modifying, with intermittent operation of the oscillator, the control signal provided thereby in dependence upon the time period between de-energisation of the oscillator and a subsequent re-energisation of the oscillator.

6. An oscillator circuit according to any one of the preceding claims wherein the transient compensation circuit is arranged for operation in a digital mode.

7. An oscillator circuit according to any one of the preceding claims further comprising a transmitter circuit for transmitting output signals provided by the oscillator.

8. An oscillator circuit according to any one of Claims 1 to 6 further comprising a signal receiver circuit, the oscillator being arranged to operate as a local oscillator for the signal receiver.

9. An oscillator circuit according to Claim 8 comprising a plurality of signal receiver circuits and a plurality of oscillators, each oscillator being arranged to operate as a local oscillator for a corresponding signal receiver circuit.

FIG.1(a)

FIG.1(b)

FIG.1(c)

FIG.2(a)

FIG.2(b)

FIG.2(c)

FIG.3(a)

FIG.3(b)

FIG.3(c)

FREQUENCY LIMIT

FREQUENCY LIMIT

$t_1$

POWER

22

21

V

23

$V_{TC}$

FIG.4

*FIG.5*

*FIG.6*